# EUROPÄISCHE PATENTANMELDUNG

(11) **EP 4 456 687 A1**
(43) Veröffentlichungstag der Anmeldung: **30.10.2024**
(21) Anmeldenummer: 23170610.2
(22) Anmeldetag: 28.04.2023
(51) Int. Cl.: H05K 7/20, B29C 39/10, B29C 65/54, H01L 23/34

(54) **BAUTEILSYSTEM**

(71) Anmelder: ZKW Group GmbH, 3250 Wieselburg (AT)
(72) Erfinder: Schwarz, Sebastian, 2624 Breitenau (AT); Rottmann, Holger, 2700 Wiener Neustadt (AT); Kieslinger, Dietmar, 2604 Theresienfeld (AT); Graf, Harald, 2732 Würflach (AT)
(74) Vertreter: Patentanwaltskanzlei Matschnig & Forsthuber OG

(57) **Zusammenfassung**

Bauteilsystem (1), umfassend zumindest zwei Bauteile (2a, 2b), zwischen welchen ein zu befüllender Hohlraum (3) ausgebildet ist, wobei der Hohlraum (3) einen Zuführabschnitt (3a) aufweist, und eine Füllvorrichtung (4) zum Befüllen des Hohlraums (3) über ein Zuführelement (4a), welches vor dem Füllvorgang in den Zuführabschnitt (3a) des Hohlraums (3) einführbar ist, wobei das Zuführelement (4a) ein Verschluss- und Abdichtelement (4b) aufweist, welches dazu eingerichtet ist, während dem Füllvorgang in einer Verschlussstellung den Zuführabschnitt (3a) des Hohlraums (3) zu verschließen und abzudichten, wobei das Verschluss- und Abdichtelement (4b) als elastisch ausdehnbarer Körper ausgestaltet ist, der zwischen der Verschlussstellung und einer Freigabestellung wechseln kann, wobei während einem Einführen des Zuführelements (4a) in den Zuführabschnitt (3a) das Verschluss- und Abdichtelement (4b) in der Freigabestellung ist und danach in die Verschlussstellung überführbar ist, wobei in der Verschlussstellung eine Bewegung des Zuführelements (4a) entgegen der Einführrichtung des Zuführelements (4a) blockiert ist.

## Beschreibung

Die Erfindung betrifft ein Bauteilsystem, umfassend:
* zumindest zwei, insbesondere miteinander verbundene, Bauteile, zwischen welchen ein zu befüllender Hohlraum ausgebildet ist, wobei der Hohlraum einen Zuführabschnitt aufweist, welcher an einer Zuführöffnung mündet, die an zumindest einem der zumindest zwei Bauteile ausgebildet ist, und
* eine Füllvorrichtung zum Befüllen des Hohlraums während eines Füllvorgangs, bei welchem Füllmaterial, insbesondere eine viskose Flüssigkeit, in den Hohlraum einfüllbar ist, wobei im befüllten Zustand, nach dem Füllvorgang, das Füllmaterial den Hohlraum im Wesentlichen vollständig ausfüllt, sodass die zumindest zwei Bauteile zumindest abschnittsweise über das Füllmaterial miteinander in Kontakt sind, wobei das Füllmaterial insbesondere ein viskoses Wärmeleitmaterial ist und/oder einen viskosen Klebstoff umfasst, wobei
* die Füllvorrichtung zum Befüllen des Hohlraums mit Füllmaterial ein Zuführelement aufweist, welches dazu eingerichtet ist, vor dem Füllvorgang durch die Zuführöffnung in den Zuführabschnitt des Hohlraums zumindest abschnittsweise, entlang einer Einführrichtung, eingeführt zu werden, sodass eine Ausgussöffnung des Zuführelements in den Zuführabschnitt ragt, wobei während dem Füllvorgang über die Ausgussöffnung Füllmaterial aus der Füllvorrichtung durch den Zuführabschnitt in den Hohlraum einbringbar ist, wobei das Zuführelement ein Verschluss- und Abdichtelement aufweist, welches dazu eingerichtet ist, während dem Füllvorgang in einer Verschlussstellung den Zuführabschnitt des Hohlraums zu verschließen und abzudichten, sodass der in den Zuführabschnitt ragende Abschnitt des Zuführelements innerhalb des Zuführabschnitts gegen ein Herausdrücken aus der Zuführöffnung, durch einen beim Befüllen vorherrschenden, gegen die Einführrichtung wirkenden, Fülldruck, gesichert ist, und die Zuführöffnung abgedichtet ist, wobei das Verschluss- und Abdichtelement weiters dazu eingerichtet ist, in einer Freigabestellung, vor und nach dem Füllvorgang, ein Einführen und ein Entnehmen des Zuführelements in und aus dem Zuführabschnitt über die Zuführöffnung zu ermöglichen.

Die Erfindung betrifft weiters ein Verfahren zum Befüllen eines Hohlraums.

Im Stand der Technik sind Bauteilsysteme, welche Bauteile und Füllvorrichtungen zum Befüllen von Hohlräumen, die zwischen den miteinander verbundenen Bauteilen ausgebildet sind, bekannt. Ein zu befüllender Hohlraum kann beispielsweise ein Luftspalt zwischen einem Kühlkörper und einer Leiterplatte sein, wobei der Luftspalt meist mit einem wärmeleitenden viskosen Füllmaterial, beispielswiese eine hochviskose Wärmeleitpaste, befüllbar ist bzw. befüllt werden soll, um die Wärmeleitung zwischen den beiden Bauteilen zu verbessern. Um hochviskose Flüssigkeiten in enge Hohlräume einzubringen ist ein hoher Einspritzdruck notwendig, was wiederum dazu führt, dass ein, die hochviskose Flüssigkeit in den Hohlraum einbringendes, Zuführelement, beispielsweise eine Einspritzdüse, an einer Zuführöffnung des Hohlraums mechanisch fixiert werden muss. Diese Fixierung muss einem Druck, welcher entgegen der Füllrichtung wirkt, standhalten. Bekannte mechanische Fixierungen (beispielsweise Schraubverschlüsse mit Dichtungen) erfordern nachteiligerweise eine komplexe Montage des Zuführelements an der Zuführöffnung und erhöhen somit den Zeitaufwand des Befüllens und benötigen oftmals zusätzlich umfassende mechanische Arretierungsmittel.

Es ist daher eine Aufgabe der vorliegenden Erfindung die Nachteile des Stands der Technik zu lindern bzw. zu beseitigen. Insbesondere ist es eine Aufgabe der Erfindung, ein Bauteilsystem zu schaffen, bei welchem ein Hohlraum zwischen zwei Bauteilen einfach und zuverlässig befüllbar ist.

Die Aufgabe wird durch ein Bauteilsystem nach Anspruch 1 und alternativ dazu durch ein Bauteilsystem nach Anspruch 11 gelöst. Die Aufgabe wird weiters durch ein Verfahren nach Anspruch 15 gelöst. Bevorzugt Ausführungsformen sind in den abhängigen Ansprüchen beschrieben.

Erfindungsgemäß ist das Verschluss- und Abdichtelement als elastisch ausdehnbarer Körper ausgestaltet, der dazu eingerichtet ist, zwischen der Verschlussstellung und der Freigabestellung zu wechseln, wobei während einem Einführen des Zuführelements in den Zuführabschnitt über die Zuführöffnung das Verschluss- und Abdichtelement in der Freigabestellung ist und, wenn das Zuführelement innerhalb des Zuführabschnitts eine Füllposition erreicht hat, in die Verschlussstellung überführbar ist, wobei in der Verschlussstellung eine das Verschluss- und Abdichtelement begrenzende Außenfläche des Verschluss- und Abdichtelements an einer den Zuführabschnitt begrenzenden Randfläche des Zuführabschnitts abdichtend anliegt und durch das Anliegen eine Bewegung des Zuführelements entgegen der Einführrichtung des Zuführelements blockiert ist, wobei nach dem Füllvorgang das Verschluss- und Abdichtelement von der Verschlussstellung in die Freigabestellung überführbar ist, wobei in der Freigabestellung die Außenfläche des Verschluss- und Abdichtelements mit der Randfläche des Zuführabschnitts im Wesentlichen kontaktfrei ist, wodurch das Verschluss- und Abdichtelement aus der Zuführöffnung und das Zuführelement, über die Zuführöffnung aus dem Zuführabschnitt, nach dem Füllvorgang, entgegen der Einführrichtung entnehmbar sind.

Dadurch ergibt sich der Vorteil, dass das Verschluss- und Abdichtelement (dessen Verschlussstellung kann auch als ein Verschlusszustand bezeichnet werden; ebenso kann dessen Freigabestellung als ein Freigabezustand bezeichnet werden) vor dem Befüllen in die Zuführöffnung einbringbar, während dem Befüllen an der Zuführöffnung (bzw. am Zuführabschnitt) verschließend und abdichtend wirkt und nach dem Befüllen aus der Zuführöffnung entnehmbar ist, wobei insbesondere keine zusätzlichen Fixierungs- oder Dichtmittel erforderlich sind. Die (temporäre) Abdichtung der Zuführöffnung sowie die Blockierung/Fixierung des Zuführelements entgegen der Einführrichtung kann insbesondere durch einen ausreichend hohen Haftkontakt zwischen der (im Verschlusszustand, insbesondere maximal, expandierten) Außenfläche des Verschluss- und Abdichtelements und der Randfläche des Zuführabschnitts erreicht werden. Im der Freigabestellen kann dieser Haftkontakt wieder gelöst werden, wodurch das Verschluss- und Abdichtelement von der Randfläche des Zuführabschnitts beabstandet ist. Das Verschluss- und Abdichtelement kann als elastisch in radialer Richtung ausdehnbarer Rundkörper ausgebildet sein.

Es kann vorgesehen sein, dass das Verschluss- und Abdichtelement als ein Elastomer-Körper ausgestaltet ist, welcher in der Verschlussstellung eine im Wesentlichen kugelförmige Form und in der Freigabestellung eine im Wesentlichen zylinderförmige Form aufweist. Der Elastomer-Körper kann insbesondere als expandierbarer bzw. aufblasbarer Ball ausgebildet sein.

Es kann vorgesehen sein, dass das Zuführelement einen Zuführkanal, mit einer Längserstreckung entlang der Einführrichtung (in einem Zustand in dem das Zuführelement in dem Zuführkanal angeordnet ist), aufweist, durch welchen das Füllmaterial leitbar ist und an dessen distalen Endabschnitt die Ausgussöffnung ausgebildet ist, wobei der Zuführkanal eine den Zuführkanal begrenzende Wandung aufweist, wobei an einem, insbesondere elastischen, Abschnitt der Wandung das Verschluss- und Abdichtelement ausgebildet ist.

Es kann vorgesehen sein, dass das Verschluss- und Abdichtelement mit dem Zuführelement einstückig, insbesondere ballonkatheterartig bzw. ballonkatheterförmig, ausgestaltet ist, wobei vorzugsweise die ballonkatheterartige bzw. ballonkatheterförmige Ausgestaltung derart ist, dass in der Verschlussstellung eine im Wesentlichen kugelförmige Form und in der Freigabestellung eine im Wesentlichen zylinderförmige Form vorliegt.

Es kann vorgesehen sein, dass die Zuführöffnung in einer Hauptschnittebene, welche orthogonal auf die Einführrichtung orientiert ist, eine Öffnungsform aufweist, welche zu einer Querschnittsform, in der Hauptschnittebene, des Zuführelements und des Verschluss- und Abdichtelements, in der Freigabestellung, korrespondierend ausgestaltet ist. Die Öffnungsform und die Querschnittsform sind bevorzugt kreisförmig ausgebildet.

Es kann vorgesehen sein, dass der Zuführabschnitt als Eintrittskanal mit einer Längserstreckung entlang der Einführrichtung ausgestaltet ist, wobei der Zuführabschnitt entlang seiner Längserstreckung zylinderförmig oder drehkegelförmig, mit einem entlang der Einführrichtung größer werdenden Drehkegelradius, ausgestaltet ist.

Es kann vorgesehen sein, dass das Füllmaterial ein TIM - thermal interface material - umfasst, welches zwischen den zumindest zwei Bauteilen einen thermischen Kontakt ausbildet. Die zumindest zwei Bauteile umfassen bevorzugt zwei Komponenten eines Kraftfahrzeugs oder eines Kraftfahrzeugscheinwerfers. Die zumindest zwei Bauteile umfassen bevorzugt ein zu kühlendes Element und ein daran befestigbares Kühlelement, beispielsweise eine Beleuchtungseinheit und einen Kühlkörper oder eine Leiterplatte und einen Kühlkörper.

Es kann vorgesehen sein, dass das Füllmaterial, insbesondere nach dem Füllvorgang, aushärtend ausgebildet ist.

Es kann vorgesehen sein, dass das Verschluss- und Abdichtelement als ein expandierbarer Elastomer-Zylinderkörper ausgestaltet ist, welcher in der Freigabestellung einen ersten Zylinderradius und in der Verschlussstellung einen zweiten Zylinderradius aufweist, wobei der erste Zylinderradius kleiner als der zweite Zylinderradius ist, wobei der Zuführabschnitt als Eintrittskanal mit einer Längserstreckung entlang der Einführrichtung ausgestaltet ist, wobei der Eintrittskanal entlang seiner Längserstreckung zylinderförmig ausgestaltet ist und einen Eintrittskanal-Zylinderradius aufweist, welcher im Wesentlichen gleich oder kleiner dem zweiten Zylinderradius des Verschluss- und Abdichtelements ist, sodass in der Verschlussstellung, während dem Befüllen des Hohlraums, eine Mantelfläche des expandierten Elastomer-Zylinderkörpers eine den Eintrittskanal begrenzende Eintrittskanal-Innenfläche abdichtend, und die Zuführöffnung verschließend, kontaktiert, wobei der Kontakt dergestalt ist, dass ein Anpressdruck von der expandierten Mantelfläche radial auf die Eintrittskanal-Innenfläche wirkt, wobei der Anpressdruck derart ist, dass eine Bewegung des Zuführelements entgegen der Einführrichtung des Zuführelements blockiert und die Zuführöffnung gegen einen Fluidaustritt abdichtend verschlossen ist. Die (temporäre) Abdichtung der Zuführöffnung sowie die Blockierung/Fixierung des Zuführelements entgegen der Einführrichtung kann insbesondere durch einen ausreichend hohen Haftkontakt bzw. einen Reibverschluss zwischen der (im Verschlusszustand, insbesondere maximal, expandierten) Mantelfläche des Verschluss- und Abdichtelements und der Eintrittskanal-Innenfläche erreicht werden. In der Freigabestellung kann dieser Haftkontakt wieder gelöst werden, wodurch das Verschluss- und Abdichtelement von der Eintrittskanal-Innenfläche beabstandet ist. Bevorzugt ist der expandierbare Abschnitt des Elastomer-Zylinderkörpers entlang der Einführrichtung im Wesentlichen gleich lang wie die Länge des Eintrittskanals entlang der Einführrichtung.

Es kann vorgesehen sein, dass der Elastomer-Zylinderkörper mit dem Zuführelement einstückig ausgebildet ist, wobei die Ausgussöffnung an einem distalen Endabschnitt des Elastomer-Zylinderkörpers angeordnet ist.

Es kann vorgesehen sein, dass der Elastomer-Zylinderkörper einen Füllkanal aufweist, durch welchen das Füllmaterial, beim Befüllen des Hohlraums, in den Hohlraum förderbar ist, wobei der expandierbare Abschnitt des Elastomer-Zylinderkörpers den Füllkanal ummantelt.

Gemäß einer Alternativlösung ist ein Bauteilsystem vorgesehen, umfassend
* zumindest zwei, insbesondere miteinander verbundene, Bauteile, zwischen welchen ein zu befüllender Hohlraum ausgebildet ist, wobei der Hohlraum einen Zuführabschnitt aufweist, welcher an einer Zuführöffnung mündet, die an zumindest einem der zumindest zwei Bauteile ausgebildet ist, und
* eine Füllvorrichtung zum Befüllen des Hohlraums während eines Füllvorgangs, bei welchem Füllmaterial, insbesondere eine viskose Flüssigkeit, in den Hohlraum einfüllbar ist, wobei im befüllten Zustand, nach dem Füllvorgang, das Füllmaterial den Hohlraum im Wesentlichen vollständig ausfüllt, sodass die zumindest zwei Bauteile zumindest abschnittsweise über das Füllmaterial miteinander in Kontakt sind, wobei das Füllmaterial insbesondere ein viskoses Wärmeleitmaterial ist und/oder einen viskosen Klebstoff umfasst, wobei
* die Füllvorrichtung zum Befüllen des Hohlraums mit Füllmaterial ein Zuführelement aufweist, welches dazu eingerichtet ist, vor dem Füllvorgang durch die Zuführöffnung in den Zuführabschnitt des Hohlraums zumindest abschnittsweise, entlang einer Einführrichtung, eingeführt zu werden, sodass eine Ausgussöffnung des Zuführelements in den Zuführabschnitt ragt, wobei während dem Füllvorgang über die Ausgussöffnung Füllmaterial aus der Füllvorrichtung durch den Zuführabschnitt in den Hohlraum einbringbar ist, wobei das Zuführelement ein Verschluss- und Abdichtelement aufweist, welches dazu eingerichtet ist, während dem Füllvorgang in einer Verschlussstellung den Zuführabschnitt des Hohlraums zu verschließen und abzudichten, sodass der in den Zuführabschnitt ragende Abschnitt des Zuführelements innerhalb des Zuführabschnitts gegen ein Herausdrücken aus der Zuführöffnung, durch einen beim Befüllen vorherrschenden, gegen die Einführrichtung wirkenden, Fülldruck, gesichert ist, und die Zuführöffnung abgedichtet ist, wobei das Verschluss- und Abdichtelement weiters dazu eingerichtet ist, in einer Freigabestellung, vor und nach dem Füllvorgang, ein Einführen und ein Entnehmen des Zuführelements in und aus dem Zuführabschnitt über die Zuführöffnung zu ermöglichen,

wobei erfindungsgemäß das Verschluss- und Abdichtelement eine zu der Zuführöffnung korrespondierende Form aufweist, um mit dem Zuführabschnitt, zur Ausbildung der Verschlussstellung, einen zweistufigen Bajonettverschlussmechanismus auszubilden, wobei zur Ausbildung einer ersten Stufe des zweistufigen Bajonettverschlussmechanismus das Verschluss- und Abdichtelement in den Zuführabschnitt über die Zuführöffnung entlang der Einführrichtung einführbar ist und im eingeführten Zustand um eine erste Achse, welche parallel zur Einführrichtung orientiert ist, drehbar ist, wobei durch eine Drehung des Verschluss- und Abdichtelements um die erste Achse, um zumindest 45°, bevorzugt im Wesentlichen 90°, ein erster Kontakt eines ersten Kontaktabschnitts des Verschluss- und Abdichtelements mit einem ersten, den Zuführabschnitt begrenzenden, Randabschnitt des Zuführabschnitts herstellbar ist, wobei der erste Kontakt derart ist, dass eine Bewegung des Verschluss- und Abdichtelements entgegen der Einführrichtung blockiert ist,
wobei zur Ausbildung der zweiten Stufe des zweistufigen Bajonettverschlussmechanismus das Verschluss- und Abdichtelement um eine zweite Achse, welche orthogonal auf die erste Achse ist, verschwenkbar ist, wobei der Drehpunkt der Verschwenkung im Wesentlichen in einem Mittelpunkt des Verschluss- und Abdichtelements liegt, wobei durch die Verschwenkung des Verschluss- und Abdichtelements um die zweite Achse um zumindest 30°, bevorzugt im Wesentlichen 45°, ein zweiter Kontakt eines zweiten Kontaktabschnitts des Verschluss- und Abdichtelements mit einem zweiten Randabschnitt des Zuführabschnitts herstellbar ist, wobei der zweite Kontakt derart ist, dass die Zuführöffnung durch das Verschluss- und Abdichtelement, insbesondere während einem Befüllen des Hohlraums mit Füllmaterial, abgedichtet ist,
wobei nach dem Befüllen des Hohlraums, durch eine Rückverschwenkung um die zweite Achse der zweite Kontakt und durch eine Rückdrehung um die erste Achse der erste Kontakt lösbar ist, um das Verschluss- und Abdichtelement in die Freigabestellung überzuführen.

Es kann vorgesehen sein, dass das Verschluss- und Abdichtelement an einem distalen Endabschnitt des Zuführelements, welcher die Ausgussöffnung aufweist, angeordnet ist.

Es kann vorgesehen sein, dass das Verschluss- und Abdichtelement als eine an zwei diametralen Kugeloberflächenabschnitten abgeflachte Kugel ausgestaltet ist.

Es kann vorgesehen sein, dass das Zuführelement als Zuführkanal ausgebildet ist, welcher an einem distalen Endabschnitt das Verschluss- und Abdichtelement aufweist, wobei das Verschluss- und Abdichtelement einen Leitungsabschnitt aufweist, welcher mit dem Zuführkanal fluidleitend verbunden ist, sodass Füllmaterial von dem Zuführkanal in den Leitungsabschnitt des Verschluss- und Abdichtelements fließen kann, wobei ein distaler Endabschnitt des Leitungsabschnitts die Ausgussöffnung aufweist.

Erfindungsgemäß ist ein Verfahren zum Befüllen eines Hohlraums vorgesehen, umfassend die folgenden Schritte:
* Bereitstellen eines Bauteilsystems, mit
   zumindest zwei, insbesondere miteinander verbundenen, Bauteilen, zwischen welchen ein zu befüllender Hohlraum ausgebildet ist, wobei der Hohlraum einen Zuführabschnitt aufweist, welcher an einer Zuführöffnung mündet, die an zumindest einem der zumindest zwei Bauteile ausgebildet ist, und
   mit einer Füllvorrichtung zum Befüllen des Hohlraums während eines Füllvorgangs, bei welchem Füllmaterial, insbesondere eine viskose Flüssigkeit, in den Hohlraum einfüllbar ist, wobei im befüllten Zustand, nach dem Füllvorgang, das Füllmaterial den Hohlraum im Wesentlichen vollständig ausfüllt, sodass die zumindest zwei Bauteile zumindest abschnittsweise über das Füllmaterial miteinander in Kontakt sind, wobei das Füllmaterial insbesondere ein viskoses Wärmeleitmaterial ist und/oder einen viskosen Klebstoff umfasst, wobei
   die Füllvorrichtung zum Befüllen des Hohlraums mit Füllmaterial ein Zuführelement aufweist, welches dazu eingerichtet ist, vor dem Füllvorgang durch die Zuführöffnung in den Zuführabschnitt des Hohlraums zumindest abschnittsweise, entlang einer Einführrichtung, eingeführt zu werden, sodass eine Ausgussöffnung des Zuführelements in den Zuführabschnitt ragt, wobei während dem Füllvorgang über die Ausgussöffnung Füllmaterial aus der Füllvorrichtung durch den Zuführabschnitt in den Hohlraum einbringbar ist, wobei das Zuführelement ein Verschluss- und Abdichtelement aufweist, welches dazu eingerichtet ist, während dem Füllvorgang in einer Verschlussstellung den Zuführabschnitt des Hohlraums zu verschließen und abzudichten, sodass der in den Zuführabschnitt ragende Abschnitt des Zuführelements innerhalb des Zuführabschnitts gegen ein Herausdrücken aus der Zuführöffnung, durch einen beim Befüllen vorherrschenden, gegen die Einführrichtung wirkenden, Fülldruck, gesichert ist, und die Zuführöffnung abgedichtet ist, wobei das Verschluss- und Abdichtelement weiters dazu eingerichtet ist, in einer Freigabestellung, vor und nach dem Füllvorgang, ein Einführen und ein Entnehmen des Zuführelements in und aus dem Zuführabschnitt über die Zuführöffnung zu ermöglichen,
* Einbringen des Zuführelements in den Zuführabschnitt,
* Überführen des Verschluss- und Abdichtelements in die Verschlussstellung, insbesondere durch Expansion eines expandierbaren Abschnitts des Verschluss- und Abdichtelements, sodass der Zuführabschnitt des Hohlraums verschlossen und abgedichtet ist,
* Füllen des Hohlraums mit Füllmaterial durch das Zuführelement,
* Überführen des Verschluss- und Abdichtelements in die Freigabestellung, insbesondere durch Kompression des expandierten Abschnitts des Verschluss- und Abdichtelements, sodass das Zuführelement aus dem Zuführabschnitt entnehmbar ist,
* Entnehmen des Zuführelements aus dem Zuführabschnitt.

### Figurenbeschreibung

Nachfolgend wird die Erfindung anhand von beispielhaften Zeichnungen näher erläutert. Hierbei zeigt
Fig. 1 eine Schnittansicht eines erfindungsgemäßen Bauteilsystems gemäß einem ersten Ausführungsbeispiel,
Fig. 2a eine Schnittansicht einer Bauteilkomponente mit einer Füllvorrichtung in Freigabestellung,
Fig. 2b eine Schnittansicht einer Bauteilkomponente mit einer Füllvorrichtung in Verschlussstellung,
Fig. 2c eine Schnittansicht einer Bauteilkomponente mit einem konischen Zuführabschnitt,
Fig. 3a eine Schnittansicht einer Bauteilkomponente gemäß einem zweiten Ausführungsbeispiel, mit einer Füllvorrichtung in Freigabestellung,
Fig. 3b die Bauteilkomponente gemäß Fig. 3a mit der Füllvorrichtung in Verschlussstellung,
Fig. 4 eine Schnittansicht eines erfindungsgemäßen Bauteilsystems gemäß einem dritten Ausführungsbeispiel, mit einer Füllvorrichtung in Freigabestellung,
Fig. 5 eine Draufsicht auf die Bauteilkomponente des Bauteilsystems gemäß Fig. 4,
Fig. 6 eine perspektivische Ansicht des Bauteilsystems gemäß Fig. 4, mit der Füllvorrichtung in Verschlussstellung.

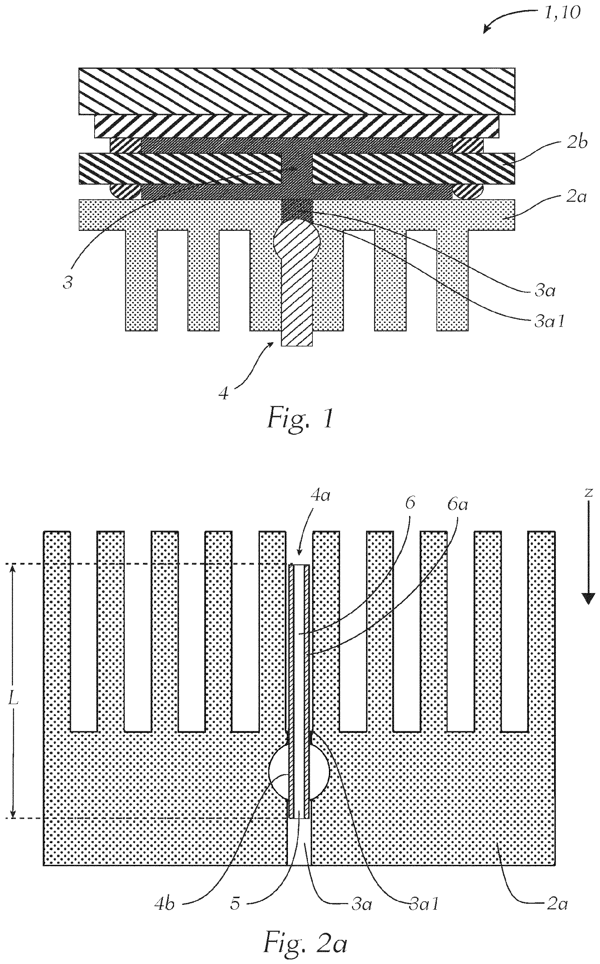

Fig. 1 zeigt eine Schnittansicht eines ersten Ausführungsbeispiels eines erfindungsgemäßen Bauteilsystems 1, umfassend zumindest zwei, insbesondere miteinander verbundene, Bauteile 2a, 2b, zwischen denen ein zu befüllender Hohlraum 3 ausgebildet ist. Der Hohlraum 3 hat einen Zuführabschnitt 3a, welcher an einer Zuführöffnung 3a1 mündet, die an dem Bauteil 2a ausgebildet ist. Der Zuführabschnitt 3a führt im Wesentlichen in den Hohlraum 3. Der Zuführabschnitt 3a ist als zylinderförmiger Eintrittskanal mit einer Längserstreckung entlang einer Einführrichtung z ausgestaltet.

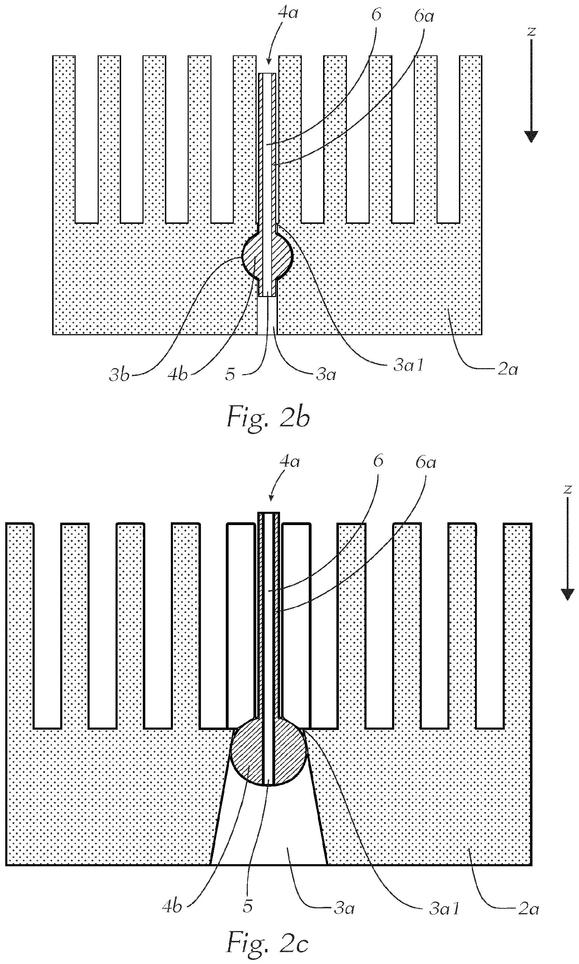

Fig. 2a und Fig. 2b zeigen eine Detailansicht einer ersten Bauteilkomponente 2a.

Das Bauteilsystem 1 umfasst weiters eine Füllvorrichtung 4 zum Befüllen des Hohlraums 3 während eines Füllvorgangs, bei welchem Füllmaterial, insbesondere eine viskose Flüssigkeit, in den Hohlraum 3 einfüllbar ist bzw. eingefüllt wird. Die Füllvorrichtung 4 ist in Fig. 1 nur schematisch dargestellt. Im befüllten Zustand, nach dem Füllvorgang, füllt das Füllmaterial den Hohlraum 3 im Wesentlichen vollständig aus, sodass die zumindest zwei Bauteile 2a, 2b zumindest abschnittsweise über das Füllmaterial miteinander in Kontakt sind. Das Füllmaterial kann insbesondere ein viskoses Wärmeleitmaterial und/oder einen viskosen Klebstoff umfassen. Das Füllmaterial kann ein TIM - thermal interface material - umfassen, welches zwischen den zumindest zwei Bauteilen 2a, 2b einen thermischen Kontakt ausbildet. Das Füllmaterial ist bevorzugt, nach dem Füllvorgang, aushärtend ausgebildet.

Die Füllvorrichtung 4 weist zum Befüllen des Hohlraums 3 mit Füllmaterial ein Zuführelement 4a auf, welches dazu eingerichtet ist, vor dem Füllvorgang durch die Zuführöffnung 3a1 in den Zuführabschnitt 3a des Hohlraums 3 zumindest abschnittsweise, entlang der Einführrichtung z, eingeführt zu werden. Im eingeführten Zustand ragt eine Ausgussöffnung 5 des Zuführelements 4a in den Zuführabschnitt 3a. Während dem Füllvorgang ist über die Ausgussöffnung 5 Füllmaterial aus der Füllvorrichtung 4 durch den Zuführabschnitt 3a in den Hohlraum 3 einbringbar. Das Zuführelement 4a umfasst einen Zuführkanal 6, mit einer Längserstreckung L entlang der Einführrichtung z, durch welchen das Füllmaterial leitbar ist und an dessen distalem Endabschnitt die Ausgussöffnung 5 ausgebildet ist. Der Zuführkanal 6 hat eine den Zuführkanal begrenzende Wandung 6a, wobei an einem, insbesondere elastischen, Abschnitt der Wandung 6a das Verschluss- und Abdichtelement 4b ausgebildet ist.

Um das Zuführelement 4a beim Befüllen in Position zu halten und die Zuführöffnung 3a1 abzudichten, weist das Zuführelement 4a ein Verschluss- und Abdichtelement 4b auf, welches dazu eingerichtet ist, während dem Füllvorgang in einer Verschlussstellung den Zuführabschnitt 3a des Hohlraums 3 zu verschließen und abzudichten. Das Verschluss- und Abdichtelement 4b stellt sicher, dass der in den Zuführabschnitt 3a ragende Abschnitt des Zuführelements 4a innerhalb des Zuführabschnitts 3a gegen ein Herausdrücken aus der Zuführöffnung 3a1, durch einen beim Befüllen vorherrschenden, gegen die Einführrichtung z wirkenden, Fülldruck, gesichert ist.

Weiter ist das Verschluss- und Abdichtelement 4b dazu eingerichtet, die Zuführöffnung 3a1 während dem Füllvorgang abzudichten. Das Verschluss- und Abdichtelement 4b ist derart ausgestaltet, dass es in einer Freigabestellung, vor und nach dem Füllvorgang, ein Einführen und ein Entnehmen des Zuführelements 4a in und aus dem Zuführabschnitt 3a über die Zuführöffnung 3a1 ermöglicht.

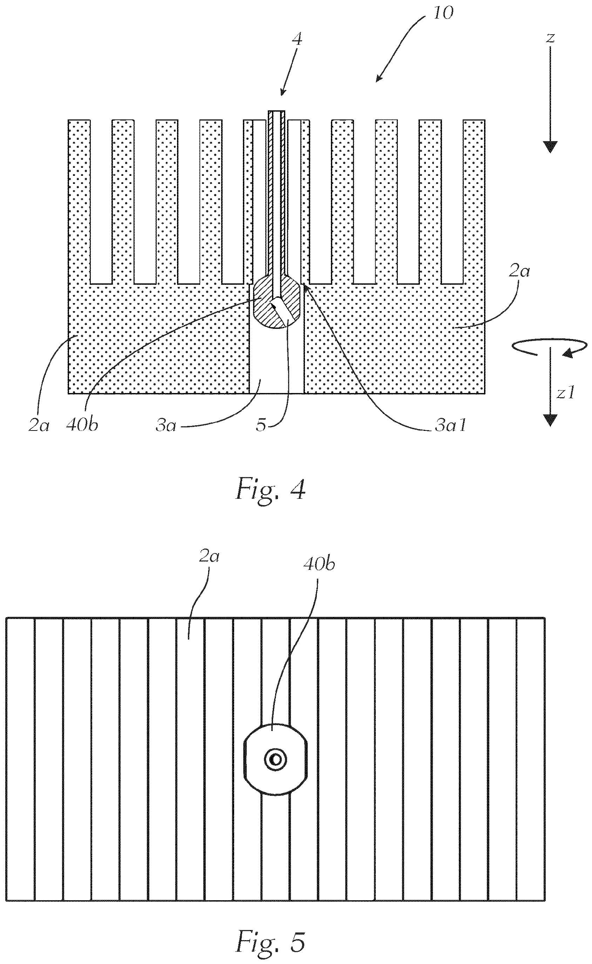

In dem in Fig. 1 gezeigten Ausführungsbeispiel kann das Verschluss- und Abdichtelement 4b als elastisch ausdehnbarer (Kugel-)Körper (im Detail: s. Fig. 2a bis 2c) oder als bajonettierbares kugelgelenkartiges Element (im Detail: s. Fig. 4 bis 6) ausgestaltet, der bzw. dass dazu eingerichtet ist, zwischen der Verschlussstellung und der Freigabestellung zu wechseln. Im Weiteren wird die Ausführungsform "elastisch ausdehnbarer Körper" näher erläutert. Die "Bajonettausführungsform" wird weiter unten zusammen mit den Fig. 4 bis 6 näher erläutert. Während einem Einführen des Zuführelements 4a in den Zuführabschnitt 3a über die Zuführöffnung 3a1 ist das Verschluss- und Abdichtelement 4b in der Freigabestellung. Dieser Zustand ist in Fig. 2a gezeigt. Das Verschluss- und Abdichtelement 4b ist in dem Ausführungsbeispiel gemäß den Fig. 1 bis 2c als ein Elastomer-Körper ausgestaltet ist, welcher in der Verschlussstellung eine im Wesentlichen kugelförmige Form und in der Freigabestellung eine im Wesentlichen zylinderförmige Form aufweist. Bevorzugt hat die Zuführöffnung 3a1 in einer Hauptschnittebene, welche orthogonal auf die Einführrichtung z orientiert ist, eine Öffnungsform, welche zu einer Querschnittsform, in der Hauptschnittebene, des Zuführelements 4a und des Verschluss- und Abdichtelements 4b, in der Freigabestellung, korrespondierend ausgestaltet ist.

Wenn das Zuführelement 4a innerhalb des Zuführabschnitts 3a eine Füllposition erreicht hat, ist das Verschluss- und Abdichtelement 4b in die Verschlussstellung überführbar. In der Verschlussstellung ist das Verschluss- und Abdichtelement 4b expandiert und daher liegt eine das Verschluss- und Abdichtelement 4b begrenzende Außenfläche des Verschluss- und Abdichtelements 4b an einer den Zuführabschnitt 3a begrenzenden Randfläche 3b des Zuführabschnitts 3a abdichtend an, und durch das Anliegen ist eine Bewegung des Zuführelements 4a entgegen der Einführrichtung des Zuführelements 4a blockiert. Dieser Zustand ist in Fig. 2b gezeigt.

Nach dem Füllvorgang ist das Verschluss- und Abdichtelement 4b von der Verschlussstellung in die Freigabestellung überführbar. In der Freigabestellung ist die Außenfläche des Verschluss- und Abdichtelements 4b mit der Randfläche 3b des Zuführabschnitts 3a im Wesentlichen kontaktfrei, wodurch das Verschluss- und Abdichtelement 4b aus der Zuführöffnung 3a1 und damit auch das Zuführelement 4a, über die Zuführöffnung 3a1 aus dem Zuführabschnitt 3a, nach dem Füllvorgang, entgegen der Einführrichtung z entnehmbar sind.

In dem Ausführungsbeispiel gemäß den Fig. 1 bis 2c ist das Verschluss- und Abdichtelement 4b mit dem Zuführelement 4a einstückig, insbesondere ballonkatheterartig bzw. ballonkatheterförmig, ausgestaltet, wobei vorzugsweise die ballonkatheterartige bzw. ballonkatheterförmige Ausgestaltung derart ist, dass in der Verschlussstellung eine im Wesentlichen kugelförmige Form und in der Freigabestellung eine im Wesentlichen zylinderförmige Form vorliegt.

In dem Ausführungsbeispiel gemäß Fig. 2c ist der Zuführabschnitt 3a entlang seiner Längserstreckung drehkegelförmig, mit einem entlang der Einführrichtung z größer werdenden Drehkegelradius, ausgestaltet.

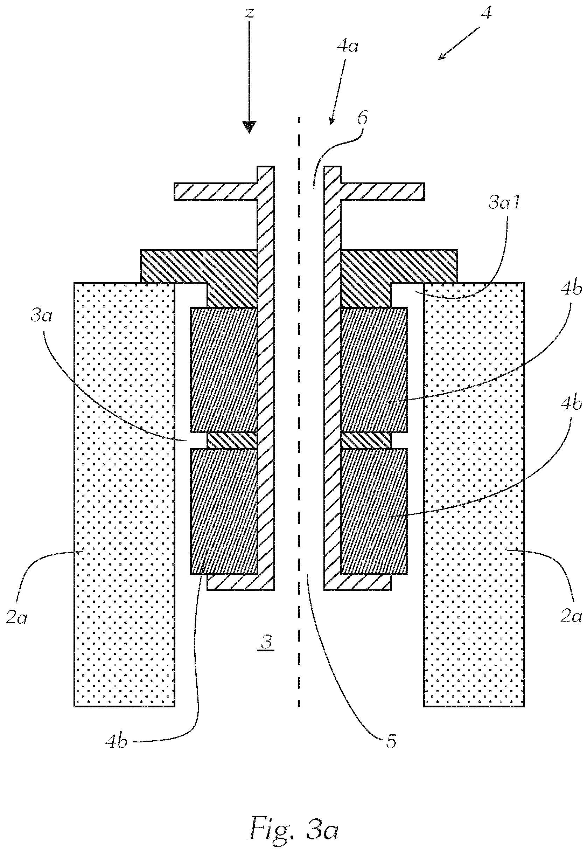

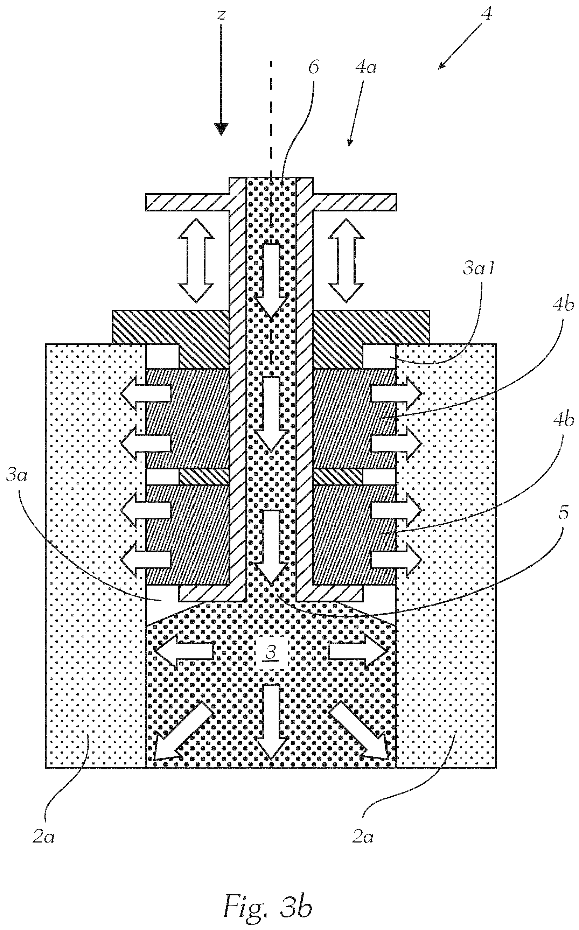

Die Fig. 3a und 3b zeigen ein zweites Ausführungsbeispiel eines Verschluss- und Abdichtelements 4b. In diesem Ausführungsbeispiel ist das Verschluss- und Abdichtelement als ein expandierbarer Elastomer-Zylinderkörper ausgestaltet. Der Elastomer-Zylinderkörper hat in der Freigabestellung einen ersten Zylinderradius und in der Verschlussstellung einen zweiten Zylinderradius. Der erste Zylinderradius ist kleiner als der zweite Zylinderradius. Der Zuführabschnitt 3a ist als Eintrittskanal mit einer Längserstreckung entlang der Einführrichtung z ausgestaltet. Der Eintrittskanal ist entlang seiner Längserstreckung zylinderförmig ausgestaltet und hat einen Eintrittskanal-Zylinderradius, welcher im Wesentlichen gleich oder kleiner dem zweiten Zylinderradius des Verschluss- und Abdichtelements 4b. Durch den variablen (bzw. vergrößerbaren und verkleinerbaren) Radius kann in der Verschlussstellung, während dem Befüllen des Hohlraums 3, eine Mantelfläche des expandierten Elastomer-Zylinderkörpers eine den Eintrittskanal begrenzende Eintrittskanal-Innenfläche abdichtend, und damit auch die Zuführöffnung 3a1 verschließend, kontaktieren. Dieser Kontakt ist dergestalt, dass ein Anpressdruck von der expandierten Mantelfläche radial auf die Eintrittskanal-Innenfläche wirkt, wobei der Anpressdruck derart ist, dass eine Bewegung des Zuführelements 4a entgegen der Einführrichtung des Zuführelements 4a, insbesondere durch einen Haftschlusskontakt, blockiert und die Zuführöffnung 3a1 gegen einen Fluidaustritt abdichtend verschlossen ist.

Der Elastomer-Zylinderkörper ist bevorzugt mit dem Zuführelement 4a einstückig ausgebildet, wobei die Ausgussöffnung 5 an einem distalen Endabschnitt des Elastomer-Zylinderkörpers angeordnet sein kann. Der Elastomer-Zylinderkörper hat einen Füllkanal, durch welchen das Füllmaterial, beim Befüllen des Hohlraums, in den Hohlraum 3 förderbar ist, wobei der expandierbare Abschnitt des Elastomer-Zylinderkörpers den Füllkanal ummantelt.

Die Fig. 4 bis 6 zeigen ein drittes Ausführungsbeispiel eines Verschluss- und Abdichtelements 40b. Auch hier umfasst das Bauteilsystem zumindest zwei, insbesondere miteinander verbundene, Bauteile 2a, 2b, zwischen welchen ein zu befüllender Hohlraum 3 ausgebildet ist.

Der Hohlraum 3 hat einen Zuführabschnitt 3a, welcher an einer Zuführöffnung 3a1 mündet, die an dem Bauteil 2a ausgebildet ist.

Das Bauteilsystem umfasst ebenfalls eine Füllvorrichtung 4 zum Befüllen des Hohlraums 3 während eines Füllvorgangs, bei welchem Füllmaterial, insbesondere eine viskose Flüssigkeit, in den Hohlraum 3 einfüllbar ist.

Die Füllvorrichtung 4 zum Befüllen des Hohlraums 3 mit Füllmaterial hat ein Zuführelement 4a, welches dazu eingerichtet ist, vor dem Füllvorgang durch die Zuführöffnung 3a1 in den Zuführabschnitt 3a des Hohlraums 3 zumindest abschnittsweise, entlang einer Einführrichtung z, eingeführt zu werden, sodass eine Ausgussöffnung 5 des Zuführelements 4a in den Zuführabschnitt 3a ragt. Während dem Füllvorgang kann über die Ausgussöffnung 5 Füllmaterial aus der Füllvorrichtung 4 durch den Zuführabschnitt 3a in den Hohlraum 3 eingebracht werden.

Das Zuführelement 4a hat ein Verschluss- und Abdichtelement 40b, welches dazu eingerichtet ist, während dem Füllvorgang in einer Verschlussstellung den Zuführabschnitt 3a des Hohlraums 3 zu verschließen und abzudichten, sodass der in den Zuführabschnitt 3a ragende Abschnitt des Zuführelements 4a innerhalb des Zuführabschnitts 3a gegen ein Herausdrücken aus der Zuführöffnung 3a1, durch einen beim Befüllen vorherrschenden, gegen die Einführrichtung z wirkenden, Fülldruck, gesichert ist. Ferner wird in der Verschlussstellung die Zuführöffnung 3a1 abgedichtet. Das Verschluss- und Abdichtelement 40b ist weiters dazu eingerichtet, in einer Freigabestellung, vor und nach dem Füllvorgang, ein Einführen und ein Entnehmen des Zuführelements 4a in und aus dem Zuführabschnitt 3a über die Zuführöffnung 3a1 zu ermöglichen.

Hierfür hat das Verschluss- und Abdichtelement 40b eine zu der Zuführöffnung 3a korrespondierende Form, um mit dem Zuführabschnitt 3a, zur Ausbildung der Verschlussstellung, einen zweistufigen Bajonettverschlussmechanismus auszubilden. Zur Ausbildung einer ersten Stufe des zweistufigen Bajonettverschlussmechanismus ist das Verschluss- und Abdichtelement 40b in den Zuführabschnitt 3a über die Zuführöffnung 3a1 entlang der Einführrichtung z einführbar und im eingeführten Zustand um eine erste Achse z1, welche parallel zur Einführrichtung z orientiert ist, drehbar. Durch diese Drehung des Verschluss- und Abdichtelements 40b um die erste Achse z1, um zumindest 45°, bevorzugt im Wesentlichen 90°, ist ein erster Kontakt eines ersten Kontaktabschnitts des Verschluss- und Abdichtelements 40b mit einem ersten, den Zuführabschnitt 3a begrenzenden, Randabschnitt des Zuführabschnitts 3a herstellbar. Durch den ersten Kontakt ist eine Bewegung des Verschluss- und Abdichtelements 40b entgegen der Einführrichtung z blockiert.

Zur Ausbildung der zweiten Stufe des zweistufigen Bajonettverschlussmechanismus ist das Verschluss- und Abdichtelement 40b um eine zweite Achse x, welche orthogonal auf die erste Achse z1 ist, verschwenkbar. Der Drehpunkt dieser Verschwenkung liegt im Wesentlichen in einem Mittelpunkt des Verschluss- und Abdichtelements 40b. Durch die Verschwenkung des Verschluss- und Abdichtelements 40b um die zweite Achse x um zumindest 30°, bevorzugt im Wesentlichen 45°, ist ein zweiter Kontakt eines zweiten Kontaktabschnitts des Verschluss- und Abdichtelements 40b mit einem zweiten Randabschnitt des Zuführabschnitts 3a herstellbar. Durch den zweiten Kontakt ist die Zuführöffnung 3a1 durch das Verschluss- und Abdichtelements 40b, insbesondere während einem Befüllen des Hohlraums 3 mit Füllmaterial, abgedichtet.

Nach dem Befüllen des Hohlraums, ist durch eine Rückverschwenkung um die zweite Achse x der zweite Kontakt und durch eine Rückdrehung um die erste Achse z1 der erste Kontakt lösbar, um das Verschluss- und Abdichtelement 40b in die Freigabestellung überzuführen.

Wie in Fig. 5 ersichtlich, ist das Verschluss- und Abdichtelement 40b ist als eine an zwei diametralen Kugeloberflächenabschnitten abgeflachte Kugel ausgestaltet. Die Zuführöffnung 3a1 hat eine dazu komplementäre Form.

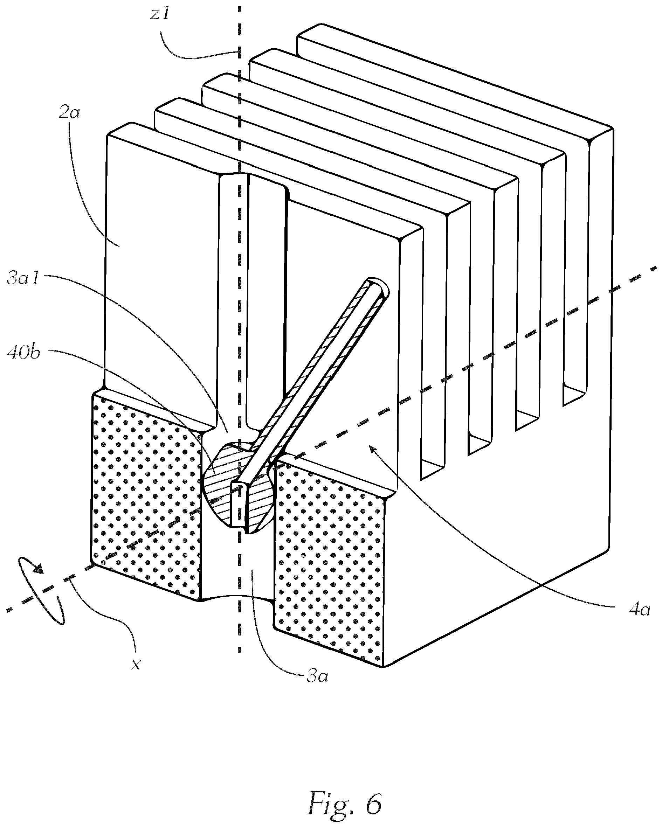

Wie in Fig. 6 ersichtlich, ist das Verschluss- und Abdichtelement 40b an einem distalen Endabschnitt des Zuführelements 40a, welcher die Ausgussöffnung 5 aufweist, angeordnet.

Das Zuführelement 4a ist als Zuführkanal ausgebildet ist, welcher an einem distalen Endabschnitt das Verschluss- und Abdichtelement 40b aufweist. Das Verschluss- und Abdichtelement 40b hat einen Leitungsabschnitt, welcher mit dem Zuführkanal fluidleitend verbunden ist, sodass Füllmaterial von dem Zuführkanal in den Leitungsabschnitt des Verschluss- und Abdichtelements 40b fließen kann, wobei ein distaler Endabschnitt des Leitungsabschnitts die Ausgussöffnung 5 aufweist.

### LISTE DER BEZUGSZEICHEN

- 1, 10: Bauteilsystem
- 2a, 2b: Bauteile
- 3: Hohlraum
- 3a: Zuführabschnitt
- 3a1: Zuführöffnung
- 3b: Randfläche
- 4: Füllvorrichtung
- 4a: Zuführelement
- 4b, 40b: Verschluss- und Abdichtelement
- 5: Ausgussöffnung
- 6: Zuführkanal
- 6a: Wandung
- L: Längserstreckung
- x: zweite Achse
- z: Einführrichtung
- z1: erste Achse

## Patentansprüche

1. Bauteilsystem (1), umfassend
* zumindest zwei, insbesondere miteinander verbundene, Bauteile (2a, 2b), zwischen welchen ein zu befüllender Hohlraum (3) ausgebildet ist, wobei der Hohlraum (3) einen Zuführabschnitt (3a) aufweist, welcher an einer Zuführöffnung (3a1) mündet, die an zumindest einem der zumindest zwei Bauteile (2a, 2b) ausgebildet ist, und
* eine Füllvorrichtung (4) zum Befüllen des Hohlraums (3) während eines Füllvorgangs, bei welchem Füllmaterial, insbesondere eine viskose Flüssigkeit, in den Hohlraum (3) einfüllbar ist, wobei im befüllten Zustand, nach dem Füllvorgang, das Füllmaterial den Hohlraum (3) im Wesentlichen vollständig ausfüllt, sodass die zumindest zwei Bauteile (2a, 2b) zumindest abschnittsweise über das Füllmaterial miteinander in Kontakt sind, wobei das Füllmaterial insbesondere ein viskoses Wärmeleitmaterial ist und/oder einen viskosen Klebstoff umfasst, wobei
* die Füllvorrichtung (4) zum Befüllen des Hohlraums (3) mit Füllmaterial ein Zuführelement (4a) aufweist, welches dazu eingerichtet ist, vor dem Füllvorgang durch die Zuführöffnung (3a1) in den Zuführabschnitt (3a) des Hohlraums (3) zumindest abschnittsweise, entlang einer Einführrichtung (z), eingeführt zu werden, sodass eine Ausgussöffnung (5) des Zuführelements (4a) in den Zuführabschnitt (3a) ragt, wobei während dem Füllvorgang über die Ausgussöffnung (5) Füllmaterial aus der Füllvorrichtung (4) durch den Zuführabschnitt (3a) in den Hohlraum (3) einbringbar ist, wobei das Zuführelement (4a) ein Verschluss- und Abdichtelement (4b) aufweist, welches dazu eingerichtet ist, während dem Füllvorgang in einer Verschlussstellung den Zuführabschnitt (3a) des Hohlraums (3) zu verschließen und abzudichten, sodass der in den Zuführabschnitt (3a) ragende Abschnitt des Zuführelements (4a) innerhalb des Zuführabschnitts (3a) gegen ein Herausdrücken aus der Zuführöffnung (3a1), durch einen beim Befüllen vorherrschenden, gegen die Einführrichtung (z) wirkenden, Fülldruck, gesichert ist, und die Zuführöffnung (3a1) abgedichtet ist, wobei das Verschluss- und Abdichtelement (4b) weiters dazu eingerichtet ist, in einer Freigabestellung, vor und nach dem Füllvorgang, ein Einführen und ein Entnehmen des Zuführelements (4a) in und aus dem Zuführabschnitt (3a) über die Zuführöffnung (3a1) zu ermöglichen,
**dadurch gekennzeichnet, dass**
das Verschluss- und Abdichtelement (4b) als elastisch ausdehnbarer Körper ausgestaltet ist, der dazu eingerichtet ist, zwischen der Verschlussstellung und der Freigabestellung zu wechseln, wobei während einem Einführen des Zuführelements (4a) in den Zuführabschnitt (3a) über die Zuführöffnung (3a1) das Verschluss- und Abdichtelement (4b) in der Freigabestellung ist und, wenn das Zuführelement (4a) innerhalb des Zuführabschnitts (3a) eine Füllposition erreicht hat, in die Verschlussstellung überführbar ist, wobei in der Verschlussstellung eine das Verschluss- und Abdichtelement (4b) begrenzende Außenfläche des Verschluss- und Abdichtelements (4b) an einer den Zuführabschnitt (3a) begrenzenden Randfläche (3b) des Zuführabschnitts (3a) abdichtend anliegt und durch das Anliegen eine Bewegung des Zuführelements (4a) entgegen der Einführrichtung des Zuführelements (4a) blockiert ist, wobei nach dem Füllvorgang das Verschluss- und Abdichtelement (4b) von der Verschlussstellung in die Freigabestellung überführbar ist, wobei in der Freigabestellung die Außenfläche des Verschluss- und Abdichtelements (4b) mit der Randfläche (3b) des Zuführabschnitts (3a) im Wesentlichen kontaktfrei ist, wodurch das Verschluss- und Abdichtelement (4b) aus der Zuführöffnung (3a1) und das Zuführelement (4a), über die Zuführöffnung (3a1) aus dem Zuführabschnitt (3a), nach dem Füllvorgang, entgegen der Einführrichtung (z) entnehmbar sind.

2. Bauteilsystem (1) nach Anspruch 1, wobei das Verschluss- und Abdichtelement (4b) als ein Elastomer-Körper ausgestaltet ist, welcher in der Verschlussstellung eine im Wesentlichen kugelförmige Form und in der Freigabestellung eine im Wesentlichen zylinderförmige Form aufweist.

3. Bauteilsystem (1) nach einem der vorgehenden Ansprüche, wobei das Zuführelement (4a) einen Zuführkanal (6), mit einer Längserstreckung (L) entlang der Einführrichtung (z), aufweist, durch welchen das Füllmaterial leitbar ist und an dessen distalen Endabschnitt die Ausgussöffnung (5) ausgebildet ist, wobei der Zuführkanal (6) eine den Zuführkanal begrenzende Wandung (6a) aufweist, wobei an einem, insbesondere elastischen, Abschnitt der Wandung (6a) das Verschluss- und Abdichtelement (4b) ausgebildet ist.

4. Bauteilsystem (1) nach einem der vorgehenden Ansprüche, wobei das Verschluss- und Abdichtelement (4b) mit dem Zuführelement (4a) einstückig, insbesondere ballonkatheterartig bzw. ballonkatheterförmig, ausgestaltet ist, wobei vorzugsweise die ballonkatheterartige bzw. ballonkatheterförmige Ausgestaltung derart ist, dass in der Verschlussstellung eine im Wesentlichen kugelförmige Form und in der Freigabestellung eine im Wesentlichen zylinderförmige Form vorliegt.

5. Bauteilsystem (1) nach einem der vorgehenden Ansprüche, wobei die Zuführöffnung (3a1) in einer Hauptschnittebene, welche orthogonal auf die Einführrichtung (z) orientiert ist, eine Öffnungsform aufweist, welche zu einer Querschnittsform, in der Hauptschnittebene, des Zuführelements (4a) und des Verschluss- und Abdichtelements (4b), in der Freigabestellung, korrespondierend ausgestaltet ist.

6. Bauteilsystem (1) nach einem der vorgehenden Ansprüche, wobei der Zuführabschnitt (3a) als Eintrittskanal mit einer Längserstreckung entlang der Einführrichtung (z) ausgestaltet ist, wobei der Zuführabschnitt (3a) entlang seiner Längserstreckung zylinderförmig oder drehkegelförmig, mit einem entlang der Einführrichtung (z) größer werdenden Drehkegelradius, ausgestaltet ist.

7. Bauteilsystem (1) nach einem der vorgehenden Ansprüche, wobei das Füllmaterial ein TIM - thermal interface material - umfasst, welches zwischen den zumindest zwei Bauteilen (2a, 2b) einen thermischen Kontakt ausbildet.

8. Bauteilsystem (1) nach Anspruch 1, wobei das Verschluss- und Abdichtelement (4b) als ein expandierbarer Elastomer-Zylinderkörper ausgestaltet ist, welcher in der Freigabestellung einen ersten Zylinderradius und in der Verschlussstellung einen zweiten Zylinderradius aufweist, wobei der erste Zylinderradius kleiner als der zweite Zylinderradius ist, wobei der Zuführabschnitt (3a) als Eintrittskanal mit einer Längserstreckung entlang der Einführrichtung (z) ausgestaltet ist, wobei der Eintrittskanal entlang seiner Längserstreckung zylinderförmig ausgestaltet ist und einen Eintrittskanal-Zylinderradius aufweist, welcher im Wesentlichen gleich oder kleiner dem zweiten Zylinderradius des Verschluss- und Abdichtelements (4b) ist, sodass in der Verschlussstellung, während dem Befüllen des Hohlraums (3), eine Mantelfläche des expandierten Elastomer-Zylinderkörpers eine den Eintrittskanal begrenzende Eintrittskanal-Innenfläche abdichtend, und die Zuführöffnung (3a1) verschließend, kontaktiert, wobei der Kontakt dergestalt ist, dass ein Anpressdruck von der expandierten Mantelfläche radial auf die Eintrittskanal-Innenfläche wirkt, wobei der Anpressdruck derart ist, dass eine Bewegung des Zuführelements (4a) entgegen der Einführrichtung des Zuführelements (4a) blockiert und die Zuführöffnung (3a1) gegen einen Fluidaustritt abdichtend verschlossen ist.

9. Bauteilsystem (1) nach Anspruch 8, wobei der Elastomer-Zylinderkörper mit dem Zuführelement (4a) einstückig ausgebildet ist, wobei die Ausgussöffnung (5) an einem distalen Endabschnitt des Elastomer-Zylinderkörpers angeordnet ist.

10. Bauteilsystem (1) nach Anspruch 8 oder 9, wobei der Elastomer-Zylinderkörper einen Füllkanal aufweist, durch welchen das Füllmaterial, beim Befüllen des Hohlraums, in den Hohlraum (3) förderbar ist, wobei der expandierbare Abschnitt des Elastomer-Zylinderkörpers den Füllkanal ummantelt.

11. Bauteilsystem (10), umfassend
* zumindest zwei, insbesondere miteinander verbundene, Bauteile (2a, 2b), zwischen welchen ein zu befüllender Hohlraum (3) ausgebildet ist, wobei der Hohlraum (3) einen Zuführabschnitt (3a) aufweist, welcher an einer Zuführöffnung (3a1) mündet, die an zumindest einem der zumindest zwei Bauteile (2a, 2b) ausgebildet ist, und
* eine Füllvorrichtung (4) zum Befüllen des Hohlraums (3) während eines Füllvorgangs, bei welchem Füllmaterial, insbesondere eine viskose Flüssigkeit, in den Hohlraum (3) einfüllbar ist, wobei im befüllten Zustand, nach dem Füllvorgang, das Füllmaterial den Hohlraum (3) im Wesentlichen vollständig ausfüllt, sodass die zumindest zwei Bauteile (2a, 2b) zumindest abschnittsweise über das Füllmaterial miteinander in Kontakt sind, wobei das Füllmaterial insbesondere ein viskoses Wärmeleitmaterial ist und/oder einen viskosen Klebstoff umfasst, wobei
* die Füllvorrichtung (4) zum Befüllen des Hohlraums (3) mit Füllmaterial ein Zuführelement (4a) aufweist, welches dazu eingerichtet ist, vor dem Füllvorgang durch die Zuführöffnung (3a1) in den Zuführabschnitt (3a) des Hohlraums (3) zumindest abschnittsweise, entlang einer Einführrichtung (z), eingeführt zu werden, sodass eine Ausgussöffnung (5) des Zuführelements (4a) in den Zuführabschnitt (3a) ragt, wobei während dem Füllvorgang über die Ausgussöffnung (5) Füllmaterial aus der Füllvorrichtung (4) durch den Zuführabschnitt (3a) in den Hohlraum (3) einbringbar ist, wobei das Zuführelement (4a) ein Verschluss- und Abdichtelement (40b) aufweist, welches dazu eingerichtet ist, während dem Füllvorgang in einer Verschlussstellung den Zuführabschnitt (3a) des Hohlraums (3) zu verschließen und abzudichten, sodass der in den Zuführabschnitt (3a) ragende Abschnitt des Zuführelements (4a) innerhalb des Zuführabschnitts (3a) gegen ein Herausdrücken aus der Zuführöffnung (3a1), durch einen beim Befüllen vorherrschenden, gegen die Einführrichtung (z) wirkenden, Fülldruck, gesichert ist, und die Zuführöffnung (3a1) abgedichtet ist, wobei das Verschluss- und Abdichtelement (40b) weiters dazu eingerichtet ist, in einer Freigabestellung, vor und nach dem Füllvorgang, ein Einführen und ein Entnehmen des Zuführelements (4a) in und aus dem Zuführabschnitt (3a) über die Zuführöffnung (3a1) zu ermöglichen,
**dadurch gekennzeichnet, dass**
das Verschluss- und Abdichtelement (40b) eine zu der Zuführöffnung (3a) korrespondierende Form aufweist, um mit dem Zuführabschnitt (3a), zur Ausbildung der Verschlussstellung, einen zweistufigen Bajonettverschlussmechanismus auszubilden, wobei zur Ausbildung einer ersten Stufe des zweistufigen Bajonettverschlussmechanismus das Verschluss- und Abdichtelement (40b) in den Zuführabschnitt (3a) über die Zuführöffnung (3a1) entlang der Einführrichtung (z) einführbar ist und im eingeführten Zustand um eine erste Achse (z1), welche parallel zur Einführrichtung (z) orientiert ist, drehbar ist, wobei durch eine Drehung des Verschluss- und Abdichtelements (40b) um die erste Achse (z1), um zumindest 45°, bevorzugt im Wesentlichen 90°, ein erster Kontakt eines ersten Kontaktabschnitts des Verschluss- und Abdichtelements (40b) mit einem ersten, den Zuführabschnitt (3a) begrenzenden, Randabschnitt des Zuführabschnitts (3a) herstellbar ist, wobei der erste Kontakt derart ist, dass eine Bewegung des Verschluss- und Abdichtelements (40b) entgegen der Einführrichtung (z) blockiert ist,
wobei zur Ausbildung der zweiten Stufe des zweistufigen Bajonettverschlussmechanismus das Verschluss- und Abdichtelement (40b) um eine zweite Achse (x), welche orthogonal auf die erste Achse (z1) ist, verschwenkbar ist, wobei der Drehpunkt der Verschwenkung im Wesentlichen in einem Mittelpunkt des Verschluss- und Abdichtelements (40b) liegt, wobei durch die Verschwenkung des Verschluss- und Abdichtelements (40b) um die zweite Achse (x) um zumindest 30°, bevorzugt im Wesentlichen 45°, ein zweiter Kontakt eines zweiten Kontaktabschnitts des Verschluss- und Abdichtelements (40b) mit einem zweiten Randabschnitt des Zuführabschnitts (3a) herstellbar ist, wobei der zweite Kontakt derart ist, dass die Zuführöffnung (3a1) durch das Verschluss- und Abdichtelements (40b), insbesondere während einem Befüllen des Hohlraums (3) mit Füllmaterial, abgedichtet ist,
wobei nach dem Befüllen des Hohlraums, durch eine Rückverschwenkung um die zweite Achse (x) der zweite Kontakt und durch eine Rückdrehung um die erste Achse (z1) der erste Kontakt lösbar ist, um das Verschluss- und Abdichtelement (40b) in die Freigabestellung überzuführen.

12. Bauteilsystem (10) nach Anspruch 11, wobei das Verschluss- und Abdichtelement (40b) an einem distalen Endabschnitt des Zuführelements (40a), welcher die Ausgussöffnung (5) aufweist, angeordnet ist.

13. Bauteilsystem (10) nach Anspruch 11 oder 12, wobei das Verschluss- und Abdichtelement (40b) als eine an zwei diametralen Kugeloberflächenabschnitten abgeflachte Kugel ausgestaltet ist.

14. Bauteilsystem (10) nach einem der Ansprüche 11 bis 13, wobei das Zuführelement (4a) als Zuführkanal ausgebildet ist, welcher an einem distalen Endabschnitt das Verschluss- und Abdichtelement (40b) aufweist, wobei das Verschluss- und Abdichtelement (40b) einen Leitungsabschnitt aufweist, welcher mit dem Zuführkanal fluidleitend verbunden ist, sodass Füllmaterial von dem Zuführkanal in den Leitungsabschnitt des Verschluss- und Abdichtelements (40b) fließen kann, wobei ein distaler Endabschnitt des Leitungsabschnitts die Ausgussöffnung (5) aufweist.

15. Verfahren zum Befüllen eines Hohlraums (3), umfassend die folgenden Schritte:
* Bereitstellen eines Bauteilsystems (1, 10) nach einem der Ansprüche 1 bis 10 oder 11 bis 14, mit
zumindest zwei, insbesondere miteinander verbundenen, Bauteilen (2a, 2b), zwischen welchen ein zu befüllender Hohlraum (3) ausgebildet ist, wobei der Hohlraum (3) einen Zuführabschnitt (3a) aufweist, welcher an einer Zuführöffnung (3a1) mündet, die an zumindest einem der zumindest zwei Bauteile (2a, 2b) ausgebildet ist, und
mit einer Füllvorrichtung (4) zum Befüllen des Hohlraums (3) während eines Füllvorgangs, bei welchem Füllmaterial, insbesondere eine viskose Flüssigkeit, in den Hohlraum (3) einfüllbar ist, wobei im befüllten Zustand, nach dem Füllvorgang, das Füllmaterial den Hohlraum (3) im Wesentlichen vollständig ausfüllt, sodass die zumindest zwei Bauteile (2a, 2b) zumindest abschnittsweise über das Füllmaterial miteinander in Kontakt sind, wobei das Füllmaterial insbesondere ein viskoses Wärmeleitmaterial ist und/oder einen viskosen Klebstoff umfasst, wobei
die Füllvorrichtung (4) zum Befüllen des Hohlraums (3) mit Füllmaterial ein Zuführelement (4a) aufweist, welches dazu eingerichtet ist, vor dem Füllvorgang durch die Zuführöffnung (3a1) in den Zuführabschnitt (3a) des Hohlraums (3) zumindest abschnittsweise, entlang einer Einführrichtung (z), eingeführt zu werden, sodass eine Ausgussöffnung (5) des Zuführelements (4a) in den Zuführabschnitt (3a) ragt, wobei während dem Füllvorgang über die Ausgussöffnung (5) Füllmaterial aus der Füllvorrichtung (4) durch den Zuführabschnitt (3a) in den Hohlraum (3) einbringbar ist, wobei das Zuführelement (4a) ein Verschluss- und Abdichtelement (4b, 40b) aufweist, welches dazu eingerichtet ist, während dem Füllvorgang in einer Verschlussstellung den Zuführabschnitt (3a) des Hohlraums (3) zu verschließen und abzudichten, sodass der in den Zuführabschnitt (3a) ragende Abschnitt des Zuführelements (4a) innerhalb des Zuführabschnitts (3a) gegen ein Herausdrücken aus der Zuführöffnung (3a1), durch einen beim Befüllen vorherrschenden, gegen die Einführrichtung (z) wirkenden, Fülldruck, gesichert ist, und die Zuführöffnung (3a1) abgedichtet ist, wobei das Verschluss- und Abdichtelement (4b, 40b) weiters dazu eingerichtet ist, in einer Freigabestellung, vor und nach dem Füllvorgang, ein Einführen und ein Entnehmen des Zuführelements (4a) in und aus dem Zuführabschnitt (3a) über die Zuführöffnung (3a1) zu ermöglichen,
* Einbringen des Zuführelements (4a) in den Zuführabschnitt (3a),
* Überführen des Verschluss- und Abdichtelements (4b, 40b) in die Verschlussstellung,
* Füllen des Hohlraums (3) mit Füllmaterial durch das Zuführelement (4a),
* Überführen des Verschluss- und Abdichtelements (4b, 40b) in die Freigabestellung,
* Entnehmen des Zuführelements (4a) aus dem Zuführabschnitt (3a).
